(19) Europäisches Patentamt
European Patent Office
Office européen des brevets

(11) **EP 4 686 095 A1**

(12) **EUROPEAN PATENT APPLICATION**

(43) Date of publication:
28.01.2026 Bulletin 2026/05

(21) Application number: 24199746.9

(22) Date of filing: 11.09.2024

(51) International Patent Classification (IPC):
H03G 9/00 (2006.01)    H03G 9/02 (2006.01)

(52) Cooperative Patent Classification (CPC):
H03G 9/025; H03G 9/005

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 22.07.2024 CN 202410983822

(71) Applicant: Shenzhen Grandsun Electronic Co., Ltd.
Shenzhen, Guangdong 518116 (CN)

(72) Inventors:
• Chi, Xin
  Guangdong, 518116 (CN)

• Wu, Haiquan
  Guangdong, 518116 (CN)
• Jiang, Dejun
  Guangdong, 518116 (CN)
• Cao, Lei
  Guangdong, 518116 (CN)
• He, Guixiao
  Guangdong, 518116 (CN)
• Quan, Jinguo
  Guangdong, 518116 (CN)

(74) Representative: Angerhausen, Christoph
Boehmert & Boehmert
Anwaltspartnerschaft mbB
Pettenkoferstrasse 22
80336 München (DE)

(54) **AUDIO COMPRESSION METHOD AND AUDIO COMPRESSION APPARATUS**

(57) The present application is applicable to the technical field of audio processing, and provides an audio compression method and an audio compression apparatus. The method includes: obtaining a first audio signal to be processed; performing, by using a spectrum compensation filter, filtering processing on the first audio signal based on a preset target spectrum to obtain a second audio signal, where the target spectrum is correlated with a distorted frequency band of the audio playing device; using a preset dynamic range compressor (DRC) to process the second audio signal to obtain a compression coefficient; and outputting a compressed signal according to the compression coefficient. The method may expand a compression range, reduce an occurrence rate of distortion when playing the audio signal and improve a playing quality of the audio signal, without significantly reducing the gain of the loud sound frequency band.

FIG. 1

## Description

TECHNICAL FIELD

The present application pertains to the technical field of audio processing, and more particularly, to an audio compression method, and an audio compression apparatus.

BACKGROUND

A dynamic range compressor (Dynamic Range Compressor, DRC) is a core audio processor in an audio playing device (e.g., an earphone, a sound, a mobile phone, etc.), and is configured to compress a dynamic range of an audio signal to be played (i.e., a logarithm of a maximum amplitude and a minimum amplitude ratio of the audio signal) to a specified dynamic range. That is, when the volume (i.e., loudness) is large, the amplitude of the signal is attenuated to a threshold value (the compression coefficient set in the DRC), when the volume is small, the amplitude of the signal is appropriately increased to balance the volume of the audio signal. Thus, a peak value of the audio signal is controlled to do not exceed the acoustic output threshold (i.e., the maximum digital signal output supported by the hardware of the audio playing device in the corresponding frequency band) of the audio playing device by reducing the dynamic range of the audio signal. In this way, the audio signal output by the audio playing device adapts to a playing environment better, audibleness is improved, an occurrence of too much volume difference of the audio signal is avoided, and the audio playing device is protected from being damaged.

However, since different audio signals have different amplitudes, when the audio signals having different amplitudes are compressed to the same dynamic range, although peak values of audio signals having large amplitudes are compressed to be within the acoustic output threshold, the amplitudes of some frequency bands still exceed the acoustic output threshold and cannot be adjusted, and thus this frequency band is distorted. If the compression range is expanded and the amplitude of the audio signal is reduced, low-frequency gain is reduced for an audio signal with loud sound, distortion may also be caused, and the audibility is affected accordingly.

SUMMARY

The present application provide an audio compression method and an audio compression apparatus, which may alleviate an occurrence of distorting phenomenon during playing of audio signals, and improve the playing quality of the audio signals.

In the first aspect, the present application provides an audio compression method being applied to an audio playing device. The method includes steps of:

obtaining a first audio signal to be processed;
performing, using a spectrum compensation filter, a filtering processing on the first audio signal based on a preset target spectrum to obtain a second audio signal, wherein the target spectrum is correlated with a distorted frequency band of the audio playing device;
processing the second audio signal by using a preset dynamic range compressor (DRC) to obtain a compression coefficient; and
outputting a compressed signal according to the compression coefficient.

In one possible implementation manner, the step of obtaining the first audio signal to be processed includes:

obtaining an original audio signal to be played;
inputting the original audio signal to be played into a sound effect processing module to be processed so as to obtain a third audio signal, the third audio signal serves as the first audio signal, and the sound effect processing module includes at least one sound effect processing module;
the step of outputting the compressed signal according to the compression coefficient includes:
compressing the third audio signal according to the compression coefficient, and outputting the compressed signal.

In one possible implementation manner, an acquisition manner of the target spectrum and the spectrum compensation filter includes:

turning off the audio compensation filter, and detecting a distorted frequency band of the audio playing device after the sound effect processing module has been debugged;
determining the target spectrum according to the distorted frequency band; and
setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

In one possible implementation manner, an acquisition manner of the target spectrum and the spectrum compensation filter includes:

turning off the audio compensation filter, and detecting an acoustic output threshold curve of the audio playing device after the sound effect processing module has been debugged;
determining a compression curve based on a difference value between the acoustic output threshold curve and a frequency response curve of an audio signal output by the sound effect processing module; determining the target spectrum according to the compression curve; and

setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

In one possible implementation manner, the first audio signal is an original audio signal to be played or an audio signal obtained by attenuating the original audio signal to be played according to a preset threshold.

In one possible implementation manner, the step of outputting the compressed signal according to the compression coefficient includes:

compressing the original audio signal to be played according to the compression coefficient, and outputting the compressed signal;
an acquisition manner of the target spectrum and the spectrum compensation filter includes:

turning off the audio compensation filter, and testing an acoustic output threshold curve of the audio playing device;
determining a compression curve based on the acoustic output threshold curve and the original audio signal used for debugging;
determining the target spectrum according to the compression curve; and
setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

In one possible implementation manner, the step of outputting the compressed signal according to the compression coefficient includes:

inputting the original audio signal to be played into a sound effect processing module to be processed so as to obtain a third audio signal, the sound effect processing module includes at least one sound effect processing module; and
compressing the third audio signal according to the compression coefficient, and outputting the compressed signal;
an acquisition manner of the target spectrum and the spectrum compensation filter includes:

detecting an acoustic output threshold curve of the audio playing device after the audio compensation filter and the sound effect processing module are turned off; and
determining the compression curve based on the acoustic output threshold curve and the original audio signal used for debugging;
determining the target spectrum according to the compression curve; and
setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

In one possible implementation manner, the step of determining the compression curve based on the acoustic output threshold curve and the original audio signal used for debugging includes:
determining the compression curve based on a difference value between the acoustic output threshold curve and a frequency response curve of the original audio signal used for debugging.

In one possible implementation manner, the step of determining the compression curve based on the acoustic output threshold curve and the original audio signal used for debugging includes:
determining the compression curve based on a difference value between the acoustic output threshold curve and a frequency response curve of the fourth audio signal. The fourth audio signal is an audio signal obtained by attenuating the original audio signal used for debugging according to the preset threshold.

In one possible implementation manner, the sound effect processing unit includes an equalizer.

In one possible implementation manner, a debugging manner of the DRC includes:
performing parameter debugging according to the audio signal output by the audio compensation filter.

In one possible implementation manner, the spectrum compensation filter is an infinite impulse response (IIR) filter or a finite impulse response (FIR) filter.

In the second aspect, an audio playing device is provided. The audio playing device includes a processor, a memory and a computer program stored in the memory and executable by the processor. The processor is configured to, when executing the computer program, implement the method according to the first aspect or according to any implementation manner in the first aspect.

In the third aspect, a computer readable storage medium is provided in the present application. The computer readable storage medium stores a computer program, that, when executed by a processor, causes the processor to implement the method according to the first aspect or according to any implementation manner in the first aspect.

In the fourth aspect, a computer program product is provided in the present application. The computer program product is configured to, when executed by a processor, cause the processor to implement the method according to the first aspect or according to any implementation manner in the first aspect.

As compared to the related art, the embodiments of the present application have the following beneficial effects: the present application provides an audio compression method, in which a spectrum compensation filter is added before DRC. That is, the amplitude of the part of the audio signal corresponding to the distorted frequency band is filtered first, to enable the processed signal has the target frequency spectrum, the processed signal is input into the DRC where the compression coefficient is calculated. When the compression coefficient is used to compress the audio signal to be output, the compression range may be expanded without significantly reducing the gain of the loud sound frequency band, the occurrence of distortion during playing of the audio signal is reduced, and audibleness of the audio signal is improved.

DESCRIPTION OF THE DRAWINGS

In order to describe the technical solutions in the embodiments of the present application more clearly, a brief introduction regarding the accompanying drawings that need to be used for describing the embodiments or the existing technologies is given below. It is obvious that the accompanying drawings described below are merely some embodiments of the present application, a person of ordinary skill in the art may also obtain other drawings according to the current drawings without paying creative works.

FIG. 1 is a schematic diagram of an architecture of an audio processing system in the related art;
FIGS. 2-5 are respective schematic diagrams of compression effects of frequency response curves in the related art;
FIG. 6 is a schematic flowchart of an audio compression method according to an embodiment of the present application;
FIG. 7 is a schematic diagram of an architecture of the audio processing system according to an embodiment of the present application;
FIGS. 8-9 are respective schematic diagrams of compression effects of frequency response curves according to an embodiment of the present application;
FIG. 10 is a schematic diagram of a comparison between a frequency response curve and an acoustic output threshold curve according to an embodiment of the present application;
FIG. 11 is a schematic diagram of a compression curve according to an embodiment of the present application;
FIG. 12 is a schematic diagram of an architecture of an audio processing system according to another embodiment of the present application;
FIG. 13 is a schematic diagram of a comparison between a frequency response curve and an acoustic output threshold curve according to another embodiment of the present application;
FIG. 14 is a schematic diagram of a compression curve according to another embodiment of the present application;
FIG. 15 is a schematic diagram of an architecture of the audio processing system according to yet another embodiment of the present application;
FIG. 16 is a schematic structural diagram of an audio compression apparatus according to an embodiment of the present application;
FIG. 17 is a schematic structural diagram of an audio playing device according to an embodiment of the present application.

DETAILED DESCRIPTION OF EMBODIMENTS

As described in the description of related art, an audio playing device generally adjusts a dynamic range of an audio signal through a dynamic range compressor (DRC) to implement loudness adjustment of the audio signal. In the related art, the DRC is usually arranged after a sound effect processing module. The sound effect processing module is configured to adjust an acoustic effect of the audio signal, and different playing effects may be obtained by using different sound effect processing modules.

For example, a sound effect processing module may include, but is not limited to, an equalizer, a sound reverberator, a tone controller, a special effect, and the like. An equalizer (EQ) is consisted of a group of filters in the audio playing device, and is configured to adjust a frequency response curve of the original audio signal, to enable an audio output by the audio playing device to reach an expected acoustic effect (e.g., bass enhancement, high pitch enhancement, noise reduction, etc.). The sound reverberator is configured to enable the audio output by the audio playing device to have a spatial effect. The tone controller may change the timbre and/or tone of the original audio signal to implement a sound changing function.

Different audio playing devices have different acoustic structure designs. Thus, sound effect processing modules obtained by debugging based on the reference standard of the target acoustic effect are also different.

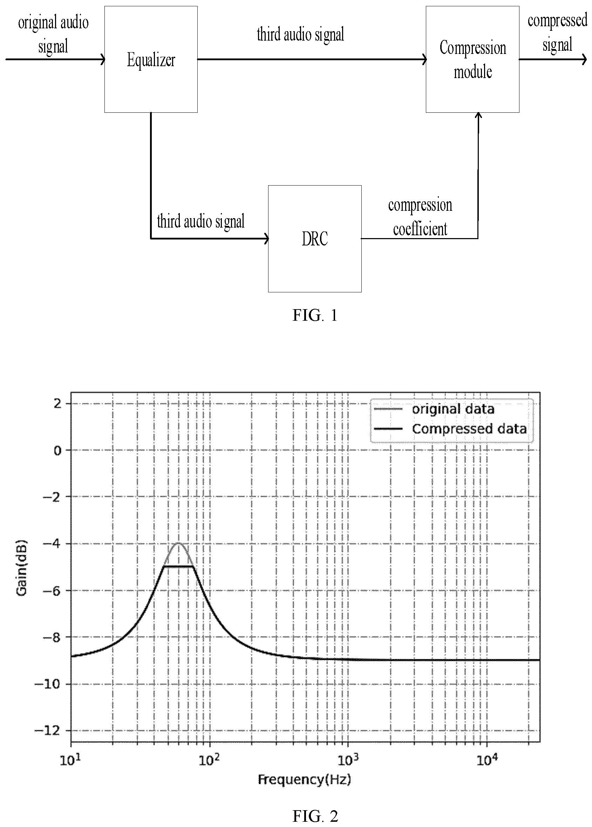

For example, FIG. 1 is a schematic diagram of an architecture of a common audio processing system in the related art. Data (the audio signal output by the sound effect processing module in the present application is referred to as a third audio signal) obtained by processing the original audio signal through the equalizer is input into the DRC to be processed to obtain a corresponding compression coefficient. Then, the third audio signal is compressed by using the compression coefficient. Finally, the compressed third audio signal is sent to a speaker for playing.

The DRC includes pre-debugged compression parameters. For example, the compression parameters include, but is not limited to, a threshold, a ratio, an attack time, a release time, and the like. Based on the compression parameter, the DRC may determine amounts of compression corresponding to the frequency bands of the third audio signal. For example, when the gain (in the unit of dBFs) of the third audio signal exceeds the threshold, the DRC starts compression in the attack time, and the gain of the corresponding frequency band in the third audio signal is attenuated below the threshold according to the compression rate, so as to determine the compression amount of the frequency band. The DRC releases the compression within the release time when the gain of the third audio signal is below the threshold. The compression coefficient at least includes compression amounts corresponding to various frequency bands of the third audio signal which have the gain exceeding the threshold.

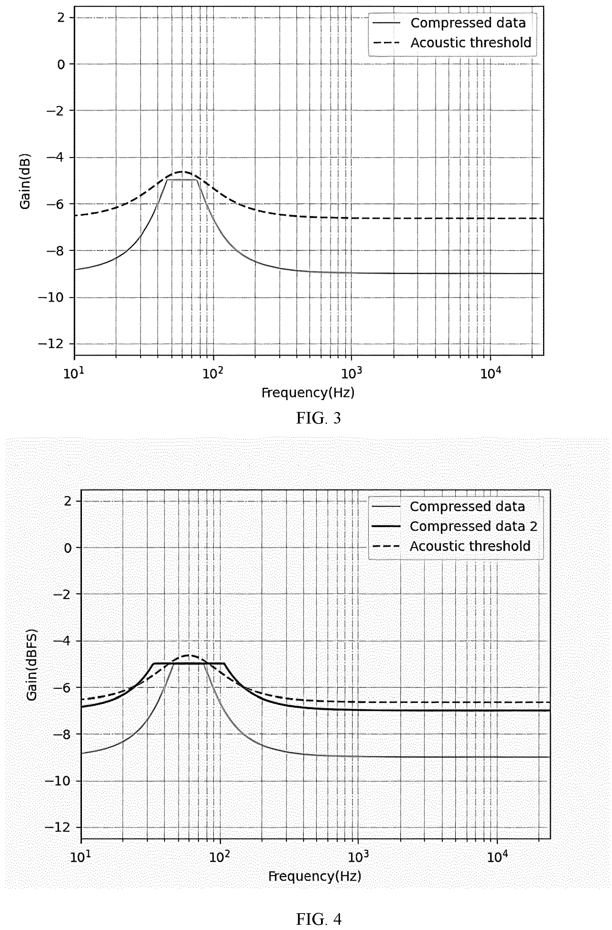

For example, as shown in FIG. 2, assuming that the threshold in the DRC is -5dBFs, the curve a is the frequency response curve of the third audio signal (the abscissa is the frequency, and the ordinate is the gain), the gain corresponding to 45Hz-80Hz exceeds -5dBFs, after the gain corresponding to 45Hz-80Hz in the third audio signal is compressed based on the compression coefficient of the DRC output, the obtained frequency response curve of the compressed signal 1 is shown as curve B, and the gain corresponding to 45Hz-80Hz in the compressed signal 1 is compressed below -5dBFs. As shown in FIG. 3, assuming that the dashed line represents an acoustic output threshold curve of the audio playing device, in an ideal state, the gain of the compressed signal 1 obtained by processing the equalizer and the DRC at each frequency band should not exceed the acoustic output threshold of the audio playing device.

However, since the compression parameter of the DRC is a fixed value obtained by debugging, it is difficult to meet the compression effect of a large amount of audio signals with different amplitudes. Moreover, since the maximum digital signal allowed to be output by the audio playing device is fluctuated rather than a fixed value in the whole frequency band, that is, the acoustic output threshold tends to present a curve along with the frequency change (e.g., the acoustic output threshold curve shown in FIG. 3), which is different from the threshold value in the DRC. Therefore, after the large-amplitude audio signal is compressed, the gains corresponding to the frequency bands may not exceed the threshold in the DRC, however, the gains corresponding to some frequency bands still exceed the acoustic output threshold, thereby resulting in distortion during playing.

For example, as shown in FIG. 4, as compared to the original audio signal of the compressed signal 1, the compressed signal 2 is obtained by processing the audio signal having a larger amplitude through the equalizer and the DRC, although the gain of the compression signal 2 is compressed into the acoustic output threshold through the DRC, an adjacent frequency band (e.g., 35 Hz, 100 Hz) of the loud sound frequency band is not compressed because that the threshold of the adjacent frequency band of the loud sound frequency band does not exceed the DRC, the audio signal output by the audio playing device at the adjacent frequency band still exceeds the acoustic output threshold of the audio playing device at the adjacent frequency band, and distortion of the signal output at the adjacent frequency band is caused.

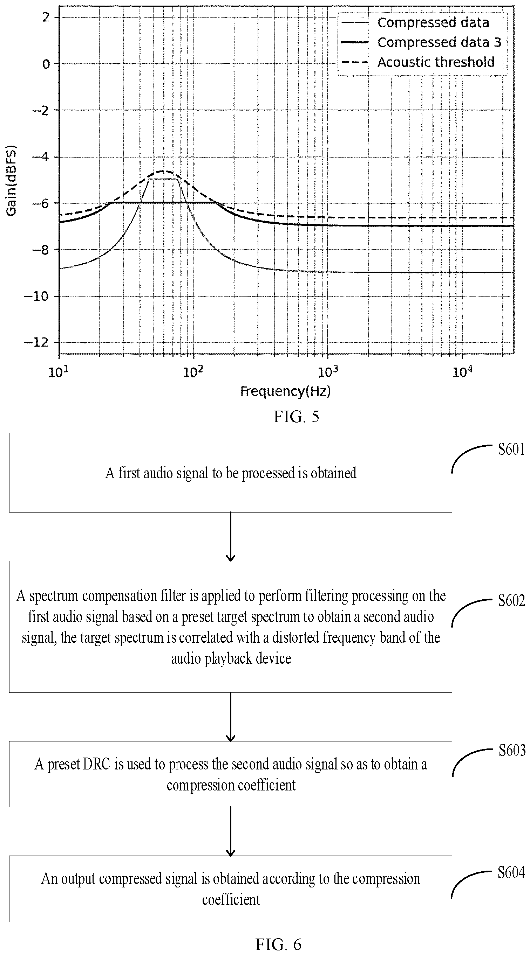

In some solutions, in order to compress the gains of the audio signal at all frequency bands into the acoustic output threshold, a greater compression range may be used. For example, as shown in FIG. 5, a threshold in the DRC is set to -6dBFs, the compressed signal 3 is obtained by setting the audio signal having larger amplitude through the equalizer and the DRC. It can be seen that, as compared to the compressed signal 2 shown in FIG. 4, although the gains of the compressed signal 3 at all frequency bands do not exceed the corresponding acoustic output threshold, the gain at the loud sound frequency band is greatly reduced, insufficient audio impression is caused, the distortion of the loud sound frequency band may also be caused.

In view of this, the present application provides an audio compression method which can expand the compression range without significantly reducing the gain of the loud sound frequency band, reduce the occurrence of distortion during playing of the audio signal, and improve a playing quality of the audio signal.

FIG. 6 is a schematic flowchart of an audio compression method according to an embodiment of the present application. The audio compression method is applied to an audio playing device, the audio playing device may be an earphone, a sound box, or any electronic device (for example, a mobile phone, a computer, a tablet, a television, etc.) that can play audio and video including the audio. As shown in FIG. 6, the audio compression method provided in the present application may include:

at step S601, a first audio signal to be processed is obtained.

The first audio signal may be a third audio signal output by the sound effect processing module, or be an original audio signal to be played, or be a signal obtained by attenuating the original audio signal to be played.

at step S602, a spectrum compensation filter is applied to perform filtering processing on the first audio signal based on a preset target spectrum to obtain a second audio signal. The target spectrum is correlated with a distorted frequency band of the audio playing device.

In this application, the spectrum compensation filter is added before the DRC and is used to filter the first audio signal to be input into the DRC to adjust the amplitude of the first audio signal corresponding to the distorted frequency band of the audio playing device, in order to enable the spectrum of the adjusted second audio signal to be the target spectrum.

The spectrum compensation filter may be any filter capable of attenuating the amplitude of the digital signal. For example, the spectrum compensation filter may be an infinite impulse response (infinite impulse response, IIR) filter or a finite impulse response (finite impulse response, FIR) filter.

The distorted frequency band of the audio playing device refers to a frequency range in which distortion occurs when the audio playing device plays a frequency sweep signal (i.e., a pure tone signal with a maximum amplitude) at a maximum volume (i.e., the maximum amplitude is 0dBFS). The filtering range of the spectrum compensation filter may be the same as the distorted frequency band, or include a distorted frequency band. Specifically, adaptive debugging may be performed according to an actual compression effect requirement.

In this embodiment of the present application, after the spectrum compensation filter performs spectrum compensation on the first audio signal, the amplitude corresponding to the distorted frequency band in the first audio signal is compressed. That is, compared with the spectrum of the first audio signal, the waveform of the spectrum of the second audio signal corresponding to the distorted frequency band is smoother.

At step S603, a preset DRC is used to process the second audio signal so as to obtain a compression coefficient.

In this embodiment of the present application, since the spectrum compensation filter is added before the DRC, the parameters (e.g., the threshold, the compression rate, the attack time, the release time, etc.) in the DRC are obtained by debugging according to the audio signal output by the spectrum compensation filter. Since the waveform of the audio signal processed by the spectrum compensation filter is smoother, when calculating the compression coefficient corresponding to the second audio signal by the debugged DRC, the DRC obtained through debugging may obtain a greater compression range.

At step S604, an output compressed signal is obtained according to the compression coefficient.

In this embodiment of the present application, after obtaining the compression coefficient corresponding to the second audio signal, the audio playing device may compress the audio signal to be played to obtain the compressed signal. For example, when the audio processing system of the audio playing device is provided with the sound effect processing module, the audio playing device may use the compression coefficient to compress the audio signal output by the sound effect processing module to obtain the compressed signal. When the audio processing system is not provided with the sound effect processing module, the audio playing device may use the compression coefficient to compress the original audio signal to be played to obtain the compressed signal. The obtained compressed signal will be sent to the speaker of the audio playing device to be played.

According to the audio compression method provided in this embodiment of the present application, the spectrum compensation filter is added before the DRC, spectrum compensation is performed on the first audio signal first, the amplitude of the part of the first audio signal corresponding to the distorted frequency band is filtered, the processed signal is input into the DRC and the compression coefficient is calculated. When the compression coefficient is used to compress the audio signal to be output, the compression range may be expanded without significantly reducing the gain of the loud sound frequency band, the situation of distortion during playing of the audio signal is reduced, and the playing quality of the audio signal is improved.

The audio compression method provided in the present application is exemplarily described below with reference to the embodiments. The embodiments described below may be combined with each other, the same or similar concepts or processes may not be repeatedly described in some embodiments.

In addition, the DRC, the sound effect processing module and the filter described herein are all concepts well known to a person skilled in the art, and the parameter debugging method and the signal processing flow are also known to the person skilled in the art. Therefore, the DRC, the sound effect processing module, the specific debugging process of the filter and the signal processing flow are not repeatedly described herein.

For the audio processing system including the sound effect processing module, in an example, the spectrum compensation filter may be arranged between the sound effect processing module and the DRC, and the first audio signal may be the third audio signal output by the sound effect processing module.

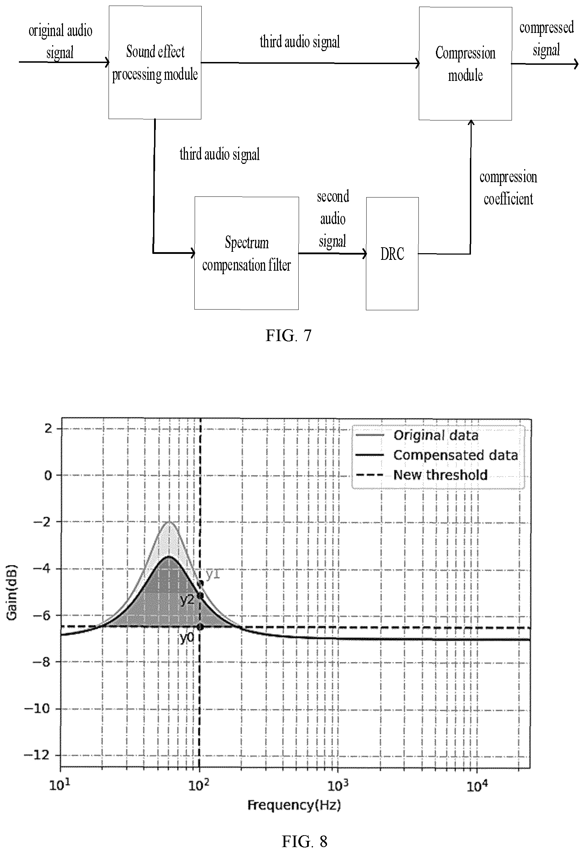

For example, as shown in FIG. 7, the audio processing system may include a sound effect processing module, a spectrum compensation filter, a DRC, and a compression module. The sound effect processing module includes at least one sound effect processor, such as an equalizer, a sound reverberator, a tone controller, a special effect, and the like.

After the original audio signal to be played is input into the audio processing system, the original audio signal to be played is first processed by the sound effect processing module to obtain the third audio signal. The third audio signal is respectively input to the compression module and the spectrum compensation filter. The spectrum compensation filter performs spectrum compensation on the third audio signal output by the sound effect processing module, and adjusts the amplitude of the part of the third audio signal corresponding to the distorted frequency band to obtain the second audio signal. The second audio signal is input into the DRC, and a compression coefficient corresponding to the second audio signal is calculated according to the pre-debugged parameter. The obtained compression coefficient is input to the compression module. The compression module compresses uses the compression coefficient to compress the third audio signal to be output to obtain a compressed signal. The compressed signal will be sent to the loudspeaker to be played.

For example, assuming that the distorted frequency band of the audio playing device ranges from 30 Hz to 100 Hz, a filtering range of the spectrum compensation filter ranges from 20 Hz to 200 Hz. As shown in FIG. 8, as compared to the frequency response curve of the third audio signal output by the sound effect processing module, the waveform corresponding to the distorted frequency band of the frequency response curve of the second audio signal obtained after performing spectrum compensation on the third audio signal through the spectrum compensation filter is relatively smooth.

It can be understood that, in this embodiment of the present application, the parameters in the DRC are obtained by debugging according to the audio signal output by the spectrum compensation filter. Since the waveform corresponding to the distorted frequency band of the audio signal output by the spectrum compensation filter is more smooth as compared to the audio signal output by the sound effect processing module, the DRC obtained through debugging can obtain a greater compression range when calculating the compression coefficient.

For example, as shown in FIG. 8, a threshold B obtained by debugging according to the audio signal output by the sound effect processing module is greater than a threshold A obtained by debugging according to the audio signal output by the spectrum compensation filter. It can be seen that, when the compression coefficient corresponding to the third audio signal is calculated through the threshold B, the compression range is between 35 Hz and 100 Hz. When the compression coefficient corresponding to the second audio signal is calculated through the threshold A, the compression range is between 20 Hz and 200 Hz. That is, the compression range of the DRC becomes larger due to the variation in the spectrum of the audio signal input into the DRC.

Taking the amplitude corresponding to 100 Hz as an example, when the amplitude corresponding to 100 Hz is attenuated from Y1 to Y2 through compensation of the spectrum compensation filter. When the third audio signal is input into the DRC to calculate the corresponding compression coefficient, since the amplitude corresponding to 100 Hz does not exceed the threshold B, since the amplitude of the third audio signal corresponding to 100 Hz does not exceed the threshold B, the compression amount gain is 0. The compression module uses the compression coefficient to compresses the third audio signal, and the amplitude corresponding to 100 Hz will not be compressed.

When the second audio signal is input into the DRC to calculate the corresponding compression coefficient, since the amplitude corresponding to the second audio signal at 100 Hz exceeds the threshold A, after the compression amount gain is y2-A, the compression module uses the compression coefficient to compress the third audio signal, the amplitude of the obtained compressed signal corresponding to 100 Hz is expressed as:

$$y1\text{-}gain=y1\text{-}(y2\text{-}A)$$

It can be seen that, due to the expansion of the compression range, the part of the third audio signal corresponding to the distorted frequency band obtains more compression amounts, thereby further ensuring that the amplitude of the compressed signal in the distorted frequency band is within the range limited by the acoustic output threshold, and reducing the distortion when the compressed signal is played.

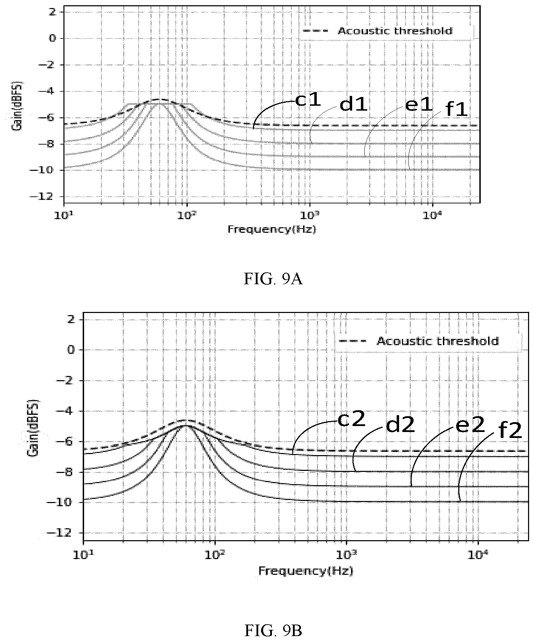

As shown in FIG. 9, FIG. 9 illustrates frequency response curves obtained by compressing the original audio signals to be played and having different amplitudes through the audio processing system shown in FIG. 1 (the curve C1, the curve D1, the curve E1, and the curve F1 as shown in FIG. 9A, and the frequency response curves obtained by compressing the original audio signals to be displayed and having different amplitudes through the audio processing system provided in the present application (the curve C2, the curve D2, the curve E2, and the curve F2 as shown in FIG. 9B, and a comparison diagram between the acoustic output threshold curves. It can be seen that the compressed signal obtained by using the audio processing system provided in the present application is compressed into the acoustic output threshold. Moreover, since the waveform of the frequency spectrum of the second audio signal corresponding to the distorted frequency band is more smooth, the compression amount calculated by the DRC changes slightly with the change of the frequency, thereby ensuring that the gain of the loud sound frequency band is not significantly reduced, and ensuring the loudness of the loud sound frequency band.

Regarding the audio processing system shown in FIG. 7, when the spectrum compensation filter is debugged, the spectrum compensation filter may be turned off first to debug the sound effect processing module. When the sound effect processing module is debugged, the distorted frequency band of the audio playing device is detected, that is, the distorted frequency range is detected through the frequency sweeping signal played at the maximum volume. The target spectrum may be determined according to the obtained distorted frequency band (i.e., the amplitude of the output signal corresponding to the distorted frequency band does not exceed the frequency spectrum of the acoustic output threshold). The initial filtering range of the spectrum compensation filter is set according to the target spectrum. Then, the spectrum compensation filter may be started, the original audio signal used for debugging is input into the audio processing system, and the compressed signal output by the audio processing system is detected. The filtering range of the spectrum compensation filter is returned and adjusted according to the detection result, the final filtering range of the spectrum compensation filter is obtained, and the debugged spectrum compensation filter is obtained accordingly.

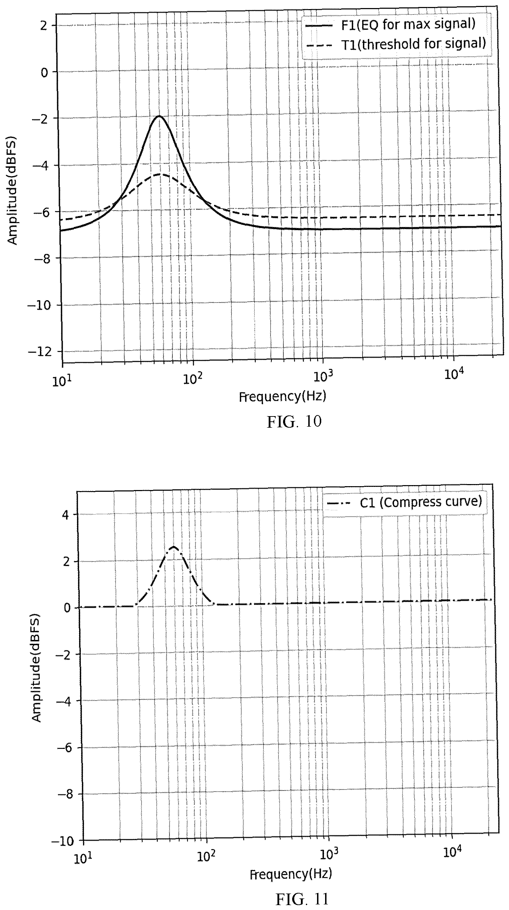

Optionally, after the sound effect processing module is debugged, the acoustic output threshold curve of the audio playing device may be detected, and the compression curve is determined based on the difference between the acoustic output threshold curve and the frequency response curve of the audio signal output by the sound effect processing module. For example, the frequency response curve of the audio signal (represented by F 1 as shown in the figures) output by the debugged audio effect processing module after processing the original audio signal for debugging, and the acoustic output threshold curve of the audio playing device may be shown in FIG. 10. After the frequency response curve is subtracted from the acoustic output threshold curve, a compression curve as shown in FIG. 11 is obtained. It may be understood that the compression curve represents the frequency band of the audio signal that needs to be compressed and is output by the sound effect processing module, that is, the distorted frequency band of the audio playing device.

Then, the target spectrum may be set according to the compression curve. Then, the initial filtering range of the spectrum compensation filter is set according to the target spectrum, the filtering range is adjusted by repeatedly testing the compression effect of the compressed signal, the final filtering range of the spectrum compensation filter is determined to obtain the debugged spectrum compensation filter.

In another example, the spectrum compensation filter may also be arranged independent of the sound effect processing module. The first audio signal may be the original audio signal to be played. Optionally, considering that the maximum amplitude of the audio signal that can be processed by most of the audio playing devices cannot be greater than 0dBFs, and the amplitude of some original audio signals in some frequency band ranges may be greater than 0dBFs. Thus, the first audio signal may also be a signal obtained by performing attenuation processing on all frequency bands of the original audio signal to be played. In this condition, the waveform of the frequency response curve of the first audio signal is the same as the waveform of the frequency response curve of the original audio signal to be played.

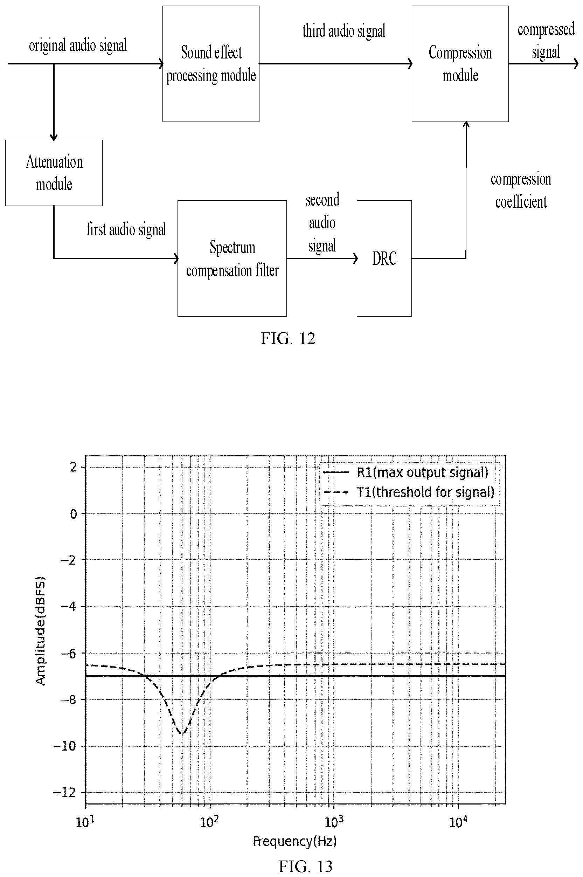

For example, the audio processing system may also include a sound effect processing module, a spectrum compensation filter, an attenuation module, a DRC, and a compression module as shown in FIG. 12. After the original audio signal to be played is input into the audio processing system, the original audio signal is input into the attenuation module and the sound effect processing module, respectively. The attenuation module first attenuates the original audio signal to be played according to a preset threshold to obtain the first audio signal. The spectrum compensation filter performs spectrum compensation on the first audio signal, and adjusts the amplitude of the part of the first audio signal corresponding to the distorted frequency band to obtain the second audio signal. The second audio signal is input into the DRC, and a compression coefficient corresponding to the second audio signal is calculated according to the pre-debugged parameter. The original audio signal to be played is processed by the sound effect processing module to obtain the third audio signal. The obtained compression coefficient and the third audio signal are input into the compression module, the compression module uses the compression coefficient to compress the third audio signal to be output to obtain the compressed signal, and the compressed signal is sent to the loudspeaker to be played.

When the spectrum compensation filter is debugged, the acoustic output threshold curve of the audio playing device may be detected when the audio compensation filter and the sound effect processing module are turned off. The original audio signal used for debugging is input into the audio processing system, and the attenuation module attenuates the original audio signal used for debugging according to a preset attenuation threshold to obtain a fourth audio signal. A compression curve is determined based on a difference value between the acoustic output threshold curve and the frequency response curve of the fourth audio signal.

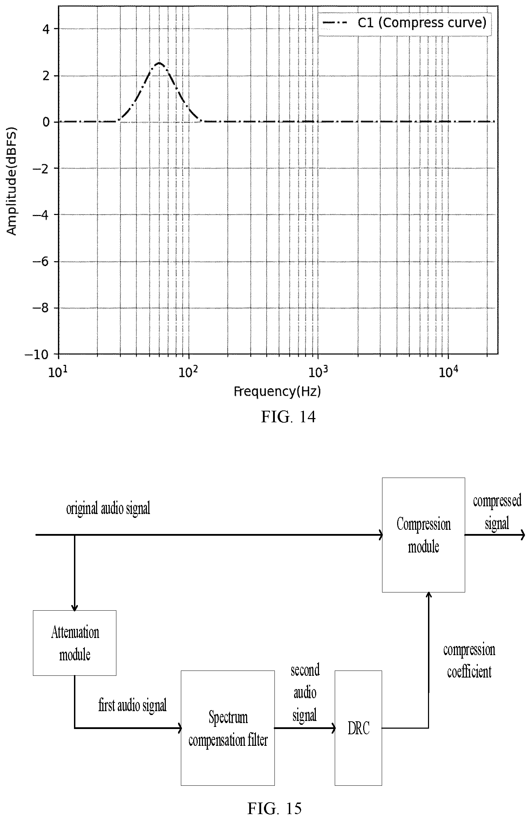

As an example, after the frequency response curve of the fourth audio signal is subtracted from the acoustic output threshold curve of the audio playing device shown in FIG. 13, the compression curve shown in FIG. 14 is obtained. It may be understood that the compression curve represents the frequency band of the original audio signal that needs to be compressed, that is, the distorted frequency band of the audio playing device.

Optionally, the frequency response curve of the original audio signal used for debugging in the audio processing system may also be directly obtained, and the compression curve is determined according to the difference between the acoustic output threshold curve and the frequency response curve of the original audio signal.

After the compression curve is obtained, the target spectrum may be set according to the compression curve. Then, the initial filtering range of the spectrum compensation filter is set according to the target spectrum, the filtering range is adjusted by repeatedly testing the compression effect of the compressed signal, and the final filtering range of the spectrum compensation filter is determined to obtain the debugged spectrum compensation filter.

It should be noted that, in the audio processing system shown in FIG. 7, the parameters of the spectrum compensation filter are changed based on the change of the parameters in the sound effect processing module. In the audio processing system shown in FIG. 12, the sound effect processing module and the spectrum compensation filter may be debugged independently, the change of the parameters in the sound effect processing module does not affect the spectrum compensation filter, and a condition that the spectrum compensation filter needs to be synchronously modified when the parameters of the sound effect processing module are adjusted is avoided.

In another scenario, the audio processing system may not be provided with any sound effect processing module. The first audio signal may be the original audio signal to be played. The first audio signal may also be a signal obtained by attenuating all frequency bands of the original audio signal to be played.

As shown in FIG. 15, FIG. 15 is another audio processing system provided in the present application. The audio processing system includes a spectrum compensation filter, an attenuation module, a DRC, and a compression module. After the original audio signal to be played is input into the audio processing system, the original audio signal is input into the attenuation module and the compression module, respectively. The attenuation module first attenuates the original audio signal to be played according to a preset threshold to obtain a first audio signal. The spectrum compensation filter performs spectrum compensation on the first audio signal to obtain a second audio signal. The second audio signal is input into the DRC, and a compression coefficient corresponding to the second audio signal is calculated according to pre-debugged parameters. The obtained compression coefficient is input into the compression module, and the compression module uses the compression coefficient to compress the original audio signal to obtain a compressed signal, and the compressed signal will be sent to the loudspeaker to be played.

Correspondingly, when the spectrum compensation filter is debugged, the acoustic output threshold curve of the audio playing device may be detected when the audio compensation filter is turned off. The original audio signal used for debugging is input into the audio processing system, and the attenuation module attenuates the original audio signal used for debugging according to a preset threshold attenuation to obtain a fourth audio signal. A compression curve is determined based on a difference value between the acoustic output threshold curve and the frequency response curve of the fourth audio signal. Alternatively, the compression curve is directly determined according to the difference between the frequency response curve of the original audio signal in the audio processing system and the acoustic output threshold curve. Then, the target spectrum may be set according to the compression curve. Then, the initial filtering range of the spectrum compensation filter is set according to the target spectrum, the filtering range is adjusted by repeatedly testing the compression effect of the compressed signal, and the final filtering range of the spectrum compensation filter is determined to obtain the debugged spectrum compensation filter.

In conclusion, by adding the spectrum compensation filter before the DRC, the compression range may be expanded without significantly reducing the gain of the loud sound frequency band, and the occurrence rate of distortion is reduced when the compressed signal is played.

Based on the same inventive concept, as an implementation of the method, one embodiment of the present application provides an audio compression apparatus. The apparatus embodiment corresponds to the method embodiments. For the convenience of reading, the apparatus embodiments do not describe detailed contents in the method embodiments. However, it should be clear that the apparatus in this embodiment may correspondingly implement all the contents in the method embodiments.

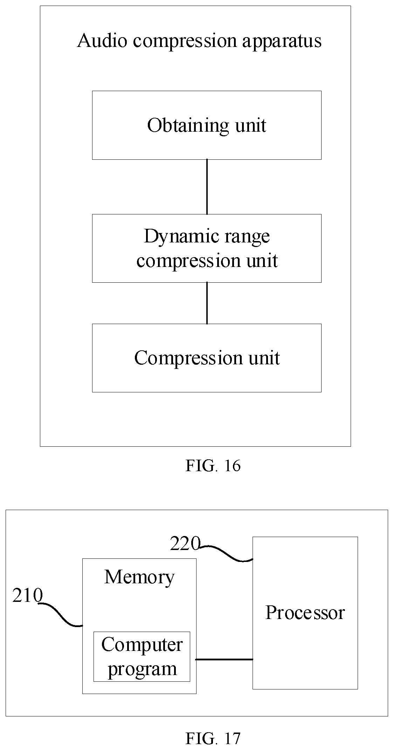

FIG. 16 is a schematic structural diagram of an audio compression apparatus according to one embodiment of the present application.

an obtaining unit configured to obtain a first audio signal to be processed;
a spectrum compensation unit configured to perform filtering processing on the input first audio signal based on a preset target spectrum to obtain a second audio signal, the target spectrum is correlated with a distorted frequency band of the audio player; and
a dynamic range compression unit configured to process the second audio signal to obtain a compression coefficient; and
the compression unit configured to output a compressed signal according to the compression coefficient.

Optionally, the obtaining unit is specifically configured to:

obtain an original audio signal to be played;
input the original audio signal to be played into a sound effect processing module to be processed to obtain a third audio signal, the third audio signal is used as the first audio signal, and the sound effect processing module includes at least one sound effect processing module;
the compression unit is specifically configured to:
compress the third audio signal according to the compression coefficient, and output the compressed signal.

Optionally, an acquisition method of the target spectrum and the spectrum compensation filter includes:

turning off the audio compensation filter, and detecting a distorted frequency band of the audio player after the sound effect processing module is debugged;

determining the target spectrum according to the distorted frequency band; and

debugging to obtain the spectrum compensation filter according to the target spectrum.

Optionally, an acquisition method of the target spectrum and the spectrum compensation filter includes:

turning off the audio compensation filter, and detecting an acoustic output threshold curve of the audio player after the sound effect processing module is debugged; and

determining a compression curve based on a difference value between an acoustic output threshold curve and a frequency response curve of an audio signal output by the sound effect processing module; and

determining the target spectrum according to the compression curve; and

performing debugging according to the target spectrum to obtain the spectrum compensation filter.

Optionally, the first audio signal is an original audio signal to be played or an audio signal obtained by attenuating an original audio signal to be played according to a preset threshold.

Optionally, the compression module is specifically configured to:

compress the original audio signal to be played according to the compression coefficient, and output the compressed signal;

an acquisition method of the target spectrum and the spectrum compensation filter is:

turning off the audio compensation filter, and testing an acoustic output threshold curve of the audio player;

determining the compression curve based on the acoustic output threshold curve and the original audio signal used for debugging;

determining the target spectrum according to the compression curve; and

obtaining the spectrum compensation filter by debugging according to the target spectrum.

Optionally, the compression module is specifically configured to:

input the original audio signal to be played into a sound effect processing module to be processed so as to obtain a third audio signal, the sound effect processing module includes at least one sound effect processing module;

compress the third audio signal according to the compression coefficient, and output the compressed signal; and

An acquisition manner of the target spectrum and the spectrum compensation filter includes:

detecting an acoustic output threshold curve of the audio player after turning off the audio compensation filter and the sound effect processing module; and

determining the compression curve based on the acoustic output threshold curve and the original audio signal used for debugging;

determining the target spectrum according to the compression curve; and

obtaining the spectrum compensation filter by debugging according to the target spectrum.

Optionally, the step of determining the compression curve based on the acoustic output threshold curve and the original audio signal used for debugging includes:

determining the compression curve based on a difference value between the acoustic output threshold curve and the frequency response curve of the original audio signal used for debugging.

Optionally, the step of determining the compression curve based on the acoustic output threshold curve and the original audio signal used for debugging includes:

determining the compression curve based on the difference between the acoustic output threshold curve and the frequency response curve of the fourth audio signal. The fourth audio signal is an audio signal obtained by attenuating the original audio signal used for debugging according to the preset threshold.

Optionally, the sound effect processing module includes an equalizer.

Optionally, a debugging manner of the dynamic range compression unit is:

performing parameter debugging according to the audio signal output by the audio compensation filtering unit.

Optionally, the spectrum compensation filtering unit is an IIR filter or an FIR filter.

The audio compression apparatus provided in this embodiment may implement the method embodiments, the implementation principle and the technical effect of the audio compression apparatus are similar to that of the method embodiments, and are not repeatedly described herein.

A person of ordinary skill in the art may clearly understand that, for the convenience of description and for conciseness, the dividing of the various functional units and functional modules is merely described according to examples. In an actual application, these functions may be assigned to different functional units and functional modules to be accomplished, that is, an inner structure of the device is divided into different functional units or modules to accomplish the whole or some of functionalities described above. The various functional units and modules in the embodiments may be integrated into a processing unit, or each of the units exists independently and physically, or two or more than two of the units are integrated into a single unit. The aforementioned integrated unit may either by actualized in the form of hardware or in the form of software functional units. In addition, specific names of the various functional units and modules are only used to be distinguished from each other conveniently, rather than being intended to limit the protection scope of the present application. Regarding the specific operating process of the units and modules in the aforementioned system, reference may be made to a corresponding process in the aforementioned method embodiments. This specific operating process of the units and modules is not repeatedly described herein.

Based on the same inventive concept, an audio playing device is further provided in one embodiment of the present application. FIG. 17 illustrates a schematic structural diagram of the audio playing device provided in the embodiments of the present application. As shown in FIG. 17, the audio playing device provided in this embodiment includes: a memory 210 and a processor 220, the memory 210 is configured to store a computer program, the processor 220 is configured to invoke the computer program to perform the method in the aforementioned method embodiment.

The audio playing device provided in this embodiment may implement the method embodiments, the implementation principle and the technical effect of the audio playing device are similar to that of the method embodiments, and are not repeatedly described herein.

A computer readable storage medium is further provided in one embodiment of the present application. The computer readable storage medium stores a computer program, that, when executed by a processor, implements the method in the method embodiment.

A computer program product is further provided in one embodiment of the present application. When the computer program product is executed by the audio playing device, the audio playing device is caused to implement the method in the method embodiment.

The aforementioned embodiments may be fully or partially implemented through software, hardware, firmware, or any combination thereof. When the embodiments are implemented using software, the embodiments can be fully or partially implemented in the form of computer program product. The computer program product includes one or more computer instructions. When loading or executing the computer program instructions on a computer, all or a part of the processes or functions described in the embodiments of the present application are generated. The computer can be a general-purpose computer, a specialized computer, a computer network, or other programmable devices. The computer instructions can be stored in a computer-readable storage medium or be transmitted from one computer-readable storage medium to another computer-readable storage medium. For example, the computer instructions can be transmitted from a website, a computer, a server or a data center to another website site, another computer, another server or another data center through a wire transmission method (e.g., a coaxial cable, a fiber optic, a digital subscriber line (DSL)) or a wireless transmission method (e.g., infrared, wireless, microwave, etc.). The computer-readable storage medium can be any available medium that can be accessed by the computer, or a data storage device such as a server or a data center containing one or more sets of available media. The available media can be a magnetic medium (e.g., a floppy disk, a hard disk, a magnetic tape), an optical medium (e.g., DVD), or a semiconductor medium. The semiconductor medium can be a solid state drive (SSD).

The ordinarily skilled one in the art may be aware of that, a whole or part of flow process of implementing the method in the aforementioned embodiments of the present application may be accomplished by using computer program to instruct relevant hardware. When the computer program is executed, the steps in the various method embodiments described above may be included. Where, the aforementioned storage medium may be diskette, optical disk, ROM (Read-Only Memory), RAM (Random Access Memory), or the like.

In the aforementioned embodiments, the descriptions of the various embodiments are emphasized respectively, regarding a part of one embodiment which has not been described or disclosed in detail, reference can be made to relevant descriptions in other embodiments.

It should be understood that, in the embodiments of the present application, the disclosed device/-terminal device and method could be implemented in other ways. For example, the device described above are merely illustrative. For example, the division of the units is only a logical function division, and other division could be used in the actual implementation. For example, multiple units or components could be combined or integrated into another system, or some features may be ignored, or not performed. In another aspect, the coupling or direct coupling or communicating connection shown or discussed could be an indirect coupling or a communicating connection through some interfaces, devices or units, and the coupling or direct coupling or communicating connection could be electrical, mechanical, or in other form.

It should be understood that, when a term "include" is used in the description and annexed claims, the term "comprise/include" indicates existence of the described characteristics, integer, steps, operations, elements and/or components, but not exclude existence or adding of one or more other characteristics, integer, steps, operations, elements, components and/or combination thereof.

In the descriptions of the present application, "/" has the meaning of "or" between two consecutive associated objects, unless otherwise there is definition of "/". For example, A/B may represent A or B. The phrase of "and/or" in the context is an association relationship for describing the associated objects, and indicates that three relationships may exist. For example, A and/or B may represent that A exists alone, A and B exist at the same time, and B exists alone. Where, A and B may be single or plural.

Moreover, in the descriptions of the present application, the term of "a plurality of" indicates two or more than two, unless otherwise the term is additionally defined. "at least one of the following items" or the similar expression indicates any combination of these items, which includes any combination of one single item or a plurality of items. For example, any of a, b, c may represent a, b, c, a-b, a-c, b-c, or a-b-c, where a, b, c may be single or plural.

As is used in the description and the annexed claims, a term "if' may be interpreted as "when" or "once" or "in response to determination" or "in response to detection". Similarly, terms such as "if it is determined that", or "if it is detected that (a described condition or event)" may be interpreted as "once it is determined" or "in response to the determination" or "once it is detected that (the described condition or event)" or "in response to the detection (the described condition or event)".

In addition, in the descriptions of the present application, terms such as "first" and "second", "third", etc., are only used for distinguishing purpose in description, but shouldn't be interpreted as indication or implication of a relative importance.

The descriptions of "referring to one embodiment" or "referring to some embodiments", or the like as described in the specification of the present application means that a specific feature, structure, or characters which are described with reference to this embodiment are included in one embodiment or some embodiments of the present application. Thus, the sentences of "in one embodiment", "in some embodiments", "in some other embodiments", "in other embodiments", and the like in this specification are not necessarily referring to the same embodiment, but instead indicate "one or more embodiments instead of all embodiments", unless otherwise they are specially emphasize in other manner.

Finally, it should be noted that, the various embodiments mentioned above are only intended to explain the technical solutions of the present application, rather than being constituted as limitations to the technical solutions of the present application. Although the present application has been described in detail with reference to these embodiments, a person of ordinary skilled in the art should understand that, the technical solutions disclosed in the embodiments may also be amended, some technical features in the technical solutions may also be equivalently replaced. The amendments or the equivalent replacements don't cause the essence of the corresponding technical solutions to deviate from the spirit and the scope of the technical solutions in the embodiments of the present application.

## Claims

1. An audio compression method applied to an audio playing device, **characterized in that**, the method comprises steps of:

    obtaining a first audio signal to be processed;
    performing, using a spectrum compensation filter, a filtering processing on the first audio signal based on a preset target spectrum to obtain a second audio signal, wherein the target spectrum is correlated with a distorted frequency band of the audio playing device;
    processing the second audio signal by using a preset dynamic range compressor (DRC) to obtain a compression coefficient; and
    outputting a compressed signal according to the compression coefficient.

2. The method according to claim 1, wherein the step of obtaining the first audio signal to be processed comprises:

    obtaining an original audio signal to be played;
    inputting the original audio signal to be played into a sound effect processing module to be processed so as to obtain a third audio signal, wherein the third audio signal serves as the first audio signal, and the sound effect processing module comprises at least one sound effect processing module;
    the step of outputting the compressed signal according to the compression coefficient comprises:
    compressing the third audio signal according to the compression coefficient, and outputting the compressed signal.

3. The method according to claim 2, wherein an acquisition manner of the target spectrum and the spectrum compensation filter comprises:

    turning off the audio compensation filter, and detecting a distorted frequency band of the audio playing device after the sound effect processing module has been debugged;
    setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

4. The method according to claim 2, wherein an acquisition manner of the target spectrum and the spectrum compensation filter comprises:

turning off the audio compensation filter, and detecting an acoustic output threshold curve of the audio playing device after the sound effect processing module has been debugged; determining a compression curve based on a difference value between the acoustic output threshold curve and a frequency response curve of an audio signal output by the sound effect processing module; determining the target spectrum according to the compression curve; and setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

5. The method according to claim 1, wherein the first audio signal is an original audio signal to be played or an audio signal obtained by attenuating the original audio signal to be played according to a preset threshold.

6. The method according to claim 5, wherein the step of outputting the compressed signal according to the compression coefficient comprises steps of:

   compressing the original audio signal to be played according to the compression coefficient, and outputting the compressed signal; an acquisition manner of the target spectrum and the spectrum compensation filter comprises:

      turning off the audio compensation filter, and testing an acoustic output threshold curve of the audio playing device; determining a compression curve based on the acoustic output threshold curve and the original audio signal used for debugging; determining the target spectrum according to the compression curve; and setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

7. The method according to claim 5, wherein the step of outputting the compressed signal according to the compression coefficient comprises steps of:

inputting the original audio signal to be played into a sound effect processing module to be processed so as to obtain a third audio signal, wherein the sound effect processing module comprises at least one sound effect processing module; and compressing the third audio signal according to the compression coefficient, and outputting the compressed signal; an acquisition manner of the target spectrum and the spectrum compensation filter comprises:

   detecting an acoustic output threshold curve of the audio playing device after the audio compensation filter and the sound effect processing module are turned off; and determining the compression curve based on the acoustic output threshold curve and the original audio signal used for debugging; determining the target spectrum according to the compression curve; and setting an initial filtering range of the spectrum compensation filter according to the target spectrum, adjusting the initial filtering range by repeatedly testing a compression effect of the compressed signal, and determining a final filtering range of the spectrum compensation filter to obtain the debugged spectrum compensation filter.

8. The method according to claim 6 or claim 7, wherein the step of determining the compression curve based on the acoustic output threshold curve and the original audio signal used for debugging comprises: determining the compression curve based on a difference value between the acoustic output threshold curve and a frequency response curve of the original audio signal used for debugging.

9. The method according to claim 6 or claim 7, wherein the step of determining the compression curve based on the acoustic output threshold curve and the original audio signal used for debugging comprises: determining the compression curve based on a difference value between the acoustic output threshold curve and a frequency response curve of the fourth audio signal, wherein the fourth audio signal is an audio signal obtained by attenuating the original audio signal used for debugging according to the preset threshold.

10. The method according to any one of claims 2-4, 7, wherein the sound effect processing module comprises an equalizer.

**11.** The method according to any one of claims 1-7, wherein a debugging manner of the DRC comprises: performing parameter debugging according to the audio signal output by the audio compensation filter.

**12.** The method according to any one of claims 1-7, wherein the spectrum compensation filter is an infinite impulse response (IIR) filter or a finite impulse response (FIR) filter.

**13.** An audio playing device, comprising a processor (220), a memory (210), and a computer program stored in the memory (210) and executable by the processor (220), wherein the processor (220) is configured to, when executing the computer program, implement the method according to any one of claims 1-12.

**14.** A computer-readable storage medium, which stores a computer program, that, when executed by a processor (220) of an audio playing device, causes the processor (220) of the audio playing device to implement the method according to any one of claims 1-12.

**15.** A computer program product, comprising a computer program, that, when executed by a processor (220) of an audio playing device, causes the processor (220) of the audio playing device to implement the method according to any one of claims 1-12.

FIG. 1

FIG. 2

FIG. 3

FIG. 4

FIG. 5

A first audio signal to be processed is obtained — S601

A spectrum compensation filter is applied to perform filtering processing on the first audio signal based on a preset target spectrum to obtain a second audio signal, the target spectrum is correlated with a distorted frequency band of the audio playback device — S602

A preset DRC is used to process the second audio signal so as to obtain a compression coefficient — S603

An output compressed signal is obtained according to the compression coefficient — S604

FIG. 6

FIG. 7

FIG. 8

FIG. 9A

FIG. 9B

FIG. 10

FIG. 11

original audio signal → Sound effect processing module → third audio signal → Compression module → compressed signal

Attenuation module

first audio signal → Spectrum compensation filter → second audio signal → DRC → compression coefficient → Compression module

FIG. 12

FIG. 13

FIG. 14

FIG. 15

Audio compression apparatus

Obtaining unit

Dynamic range
compression unit

Compression unit

FIG. 16

220

Memory

210

Computer
program

Processor

FIG. 17

| | Europäisches Patentamt |
| European Patent Office |
| Office européen des brevets |

# EUROPEAN SEARCH REPORT

**Application Number**

EP 24 19 9746

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/148605 A1 (ZHANG XIAOHONG [CN]) 12 May 2022 (2022-05-12) * paragraphs [0008], [0070], [0071], [0106] - [0112], [0121], [0130], [0131]; figures 2,4,5 * | 1-15 | INV. H03G9/00 H03G9/02 |
| A | US 2011/320210 A1 (VICKERS EARL C [US]) 29 December 2011 (2011-12-29) * paragraphs [0007], [0014], [0037], [0047] - [0053]; figures 6,7 * | 1-15 | |
| A | EP 1 889 258 B1 (BOSE CORP [US]) 1 March 2017 (2017-03-01) * paragraph [0042]; figure 3 * | 1-15 | |

**TECHNICAL FIELDS SEARCHED (IPC)**

H03G

The present search report has been drawn up for all claims

| Place of search | Date of completion of the search | Examiner |
|---|---|---|
| The Hague | 28 January 2025 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 9746

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2025

| Patent document cited in search report | | | Publication date | Patent family member(s) | | | Publication date |
|---|---|---|---|---|---|---|---|
| US 2022148605 | A1 | | 12-05-2022 | CN | 110265042 | A | 20-09-2019 |
| | | | | US | 2022148605 | A1 | 12-05-2022 |
| | | | | WO | 2020237954 | A1 | 03-12-2020 |
| US 2011320210 | A1 | | 29-12-2011 | US | 2011320210 | A1 | 29-12-2011 |
| | | | | US | 2014105418 | A1 | 17-04-2014 |
| | | | | US | 2016065161 | A1 | 03-03-2016 |
| EP 1889258 | B1 | | 01-03-2017 | CA | 2608749 | A1 | 23-11-2006 |
| | | | | CN | 101208742 | A | 25-06-2008 |
| | | | | EP | 1889258 | A1 | 20-02-2008 |
| | | | | JP | 5448446 | B2 | 19-03-2014 |
| | | | | JP | 2008546003 | A | 18-12-2008 |
| | | | | US | 2006262938 | A1 | 23-11-2006 |
| | | | | WO | 2006125061 | A1 | 23-11-2006 |

EPO FORM P0459

For more details about this annex : see Official Journal of the European Patent Office, No. 12/82